# EUROPÄISCHE PATENTSCHRIFT

(11) **EP 0 792 716 B1**
(45) Veröffentlichungstag und Bekanntmachung des Hinweises auf die Patenterteilung: **21.07.1999**
(21) Anmeldenummer: 97102851.9
(22) Anmeldetag: 21.02.1997
(51) Int. Cl.: B23K 20/00

(54) **Verfahren zur Herstellung einer geformten Drahtverbindung**
Method for making a shaped wire connection
Procédé de réalisation d'une connexion filiforme

(30) Priorität: 02.03.1996 CH 54096
(43) Veröffentlichungstag der Anmeldung: 03.09.1997
(73) Patentinhaber: ESEC SA, CH-6330 Cham/Steinhausen (CH)
(72) Erfinder: Egger, Hans, Dr., CH-5637 Beinwil (CH); Von Flüe, Daniel, 6330 Cham (CH); Stössel, Zeno, 6340 Baar (CH)

(56) Entgegenhaltungen:
- DE-A- 4 335 468
- US-A- 4 445 633
- US-A- 4 597 522
- US-A- 5 269 452
- US-A- 5 297 722

## Beschreibung

Die Erfindung betrifft ein Verfahren zur Herstellung einer geformten Drahtverbindung zwischen einem ersten, auf einem Halbleiterchip befindlichen Anschlusspunkt und einem zweiten Anschlusspunkt. Mittels solcher Drahtverbindungen werden bei der Halbleitermontage die elektrischen Verbindungen mit der auf dem Chip befindlichen integrierten Schaltung hergestellt. Der zweite Anschlusspunkt der Verbindung kann sich typischerweise auf einem metallischen sogenannten "lead frame" befinden oder auf einem anderen Systemträger, z.B. einer gedruckten Schaltung mit Kunststoff-, Keramik- oder sogenanntem "ball grid array"-Substrat, aber auch auf einem weiteren Halbleiterchip wie im Falle von Anordnungen mit mehreren Chips auf demselben Träger ("multi-chip devices").

Gemäss an sich bekannten Verfahren zur Herstellung solcher Drahtverbindungen läuft ein Draht durch eine mittels programmierbarer Antriebsvorrichtung horizontal und vertikal beweglich geführte Kapillare hindurch, die sowohl zum Befestigen des Drahtes an beiden Anschlusspunkten als auch zur Drahtführung zwischen den Anschlusspunkten dient. Jeweils nach Befestigung des Drahtes am ersten Anschlusspunkt wird die Kapillare von der genannten Antriebsvorrichtung entlang einer vorbestimmten Bahn zum zweiten Anschlusspunkt geführt. Diese Bahn bestimmt sich - bei gegebener Lage der Anschlusspunkte - aus der gewünschten bzw. vorgeschriebenen Geometrie der gebildeten Drahtbrücke. Allgemein wird dabei die Kapillare in einer ersten Bewegungsphase im wesentlichen vertikal nach oben geführt, um die benötigte Drahtlänge durchzuziehen (ggf. verbunden mit einer Vorformung des Drahtes), und anschliessend, in einer zweiten Bewegungsphase, entlang einem Bogen nach unten zum zweiten Anschlusspunkt.

Dieses auch "wire bonding" genannte Verfahren findet in der Halbleiterindustrie verbreitete Anwendung. Geeignete Antriebsvorrichtungen für die Kapillare sind z.B. aus den US-Patentschriften Nr. 5,114,302 und 4,903,883 bekannt, und verschiedene Bahnkurven der Kapillare (zur Erzeugung bestimmter Formen der Drahtbrücken) sind z.B. in den US-Patentschriften Nr. 4,327,860, 5,111,989 und 5,205,463, das als nächstliegender Stand der Tecknik angesehen wird, beschrieben.

Je nach Art und Grösse der Halbleiterchips erfordern diese oft eine hohe Zahl solcher Drahtverbindungen, die von dicht nebeneinanderliegenden Stellen auf der Chip-Oberfläche ausgehen. Dabei werden an die Formgenauigkeit und die mechanische Stabilität der erzeugten Drahtbrücken - und damit an den Bahnverlauf der Kapillare - sehr hohe Anforderungen gestellt. Bisherige Bemühungen nach dem Stand der Technik richteten sich demnach hauptsächlich auf die genaue Einhaltung und Erzeugung besonderer Formen der Bahnkurven (Trajektorien). Damit sind allerdings entsprechend hohe Rechenleistungen bzw. -zeiten der Bahnsteuerungs-Prozessoren verbunden, und an sich mögliche Fahrgeschwindigkeiten der Bewegungsmechanismen zur Führung der Kapillare werden im allgemeinen nicht voll ausgenützt.

Mit der vorliegenden Erfindung wird angestrebt, das eingangs genannte Verfahren in einer Weise weiterzuentwickeln, dass die Bahnkurven der Kapillare insgesamt rascher durchfahren werden. Dabei sollen die bestehenden dynamischen Möglichkeiten der Antriebsvorrichtung bis an die Grenzen genutzt werden, um eine Steigerung der Automaten-Produktionsleistung zu erzielen.

Diese Aufgabe wird erfindungsgemäss dadurch gelöst, dass man bei der Programmierung der Antriebsvorrichtung, mindestens in der zweiten Bewegungsphase, die Geschwindigkeit der horizontalen Bewegungskomponente vorgibt und danach sowie aufgrund der vorgegebenen Bahn die Geschwindigkeit der vertikalen Bewegungskomponente berechnet, und dass man dabei die Vorgabe der Geschwindigkeitswerte der horizontalen Bewegungskomponente nach den maximal zulässigen Horizontal- und/oder Vertikal-Beschleunigungen ausrichtet.

Das erfindungsgemässe Verfahren ist also nicht allein oder primär auf die Einhaltung der Bahnkurve (d.h. die Koordination der Horizontal- und Vertikalbewegungen) ausgerichtet, sondern in erster Linie auf die Vorgabe hoher Horizontalgeschwindigkeiten, um möglichst die noch zulässigen Beschleunigungswerte der Antriebsvorrichtung zu erreichen. Dabei wird u.a. vom (bisher nicht berücksichtigten) Umstand Gebrauch gemacht, dass die Vertikalbewegungen der Kapillare generell mit wesentlich geringerer Trägheit behaftet sind als die Horizontalbewegungen; daraus ergibt sich, dass die Vertikalkomponente als abhängige Variable praktisch immer der gegebenen Bahnkurve "folgen" kann.

Nach dem Stand der Technik wird die erste, generell vertikale Bewegungsphase, d.h. das Durchziehen der erfoderlichen Drahtlänge (ggf. verbunden mit einer Vorformung des Drahtes) immer mit einem Halt der Kapillare am höchsten Punkt der Bahn abgeschlossen, an den der abwärts führende Bogen mit etwa horizontaler Tangente anschliesst. Ein solcher Zwischenhalt bzw. die damit verbundene "Ecke" in der Bahn der Kapillare bedingt eine zusätzliche Verzögerung des Bewegungsablaufes.

Eine vorteilhafte weitere Ausgestaltung des erfindungsgemässen Verfahrens besteht nun darin, dass man die Horizontalbewegung bereits während der ersten Bewegungsphase beginnen lässt und durch simultane Vertikal- und Horizontalbewegungen einen stetigen Uebergang der Bahn von der ersten in die zweite Bewegungsphase erzeugt. Auf diese Weise können erhebliche zusätzliche Zeiteinsparungen im Vergleich zum vorerwähnten "sequentiellen" Bewegungsablauf erzielt werden.

Nachstehend wird die Erfindung anhand verschiedener Ausführungsbeispiele in Verbindung mit der Zeichnung näher erläutert.
- Fig. 1: ist die vereinfachte Draufsicht einer an sich bekannten Anordnung zur Durchführung des Verfahrens;
- Fig. 2: zeigt einen Teil der Anordnung nach Fig. 1 von der Seite und stark vergrössert;
- Fig. 3: stellt eine fertiggestellte, beispielsweise Drahtverbindung dar;
- Fig. 4: zeigt ein einfaches, erstes Beispiel einer Bahn, die die Kapillare vom ersten zum zweiten Anschlusspunkt durchläuft;
- Fig. 5: zeigt die zugehörigen Zeitdiagramme der horizontalen und vertikalen Geschwindigkeiten und Beschleunigungen;
- Fig. 6: stellt ein zweites Beispiel einer Kapillarenbahn dar, und
- Fig. 7: zeigt die der Bahn nach Fig. 6 entsprechenden Zeitdiagramme analog der Fig. 5.

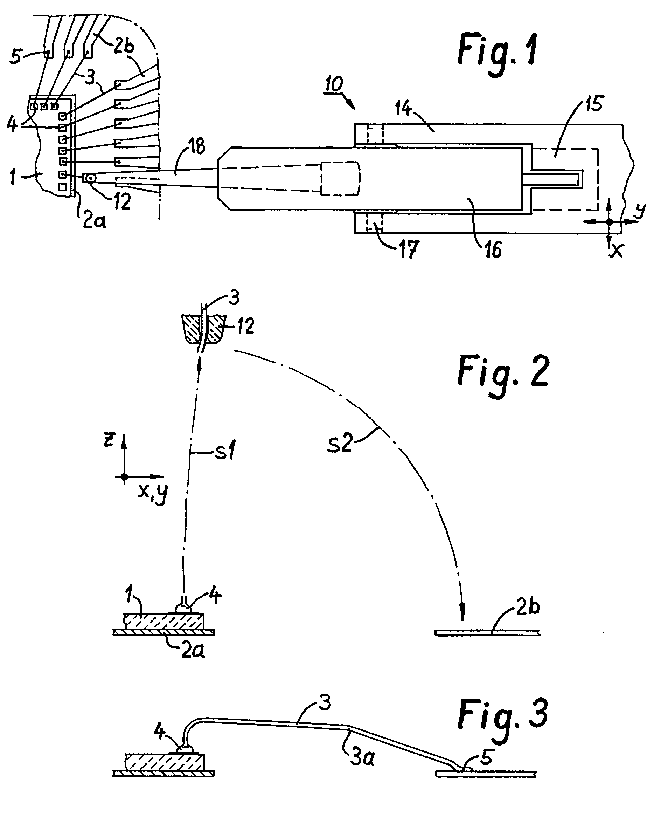

In den Figuren 1 und 2 ist eine generelle Anordnung, mit der das erfindungsgemässe Verfahren durchgeführt wird, schematisch veranschaulicht. Als Werkstück ist links in Fig. 1 ausschnittweise ein Halbleiterchip 1, der auf einem Systemträger montiert ist, dargestellt. Der Systemträger, typischerweise aus gestanztem oder geätztem Kupferblech gefertigt, weist im wesentlichen die den Chip 1 tragende Insel 2a und ringsum angeordnete Kontaktfinger 2b auf.

Bei dem als "wire bonding" bezeichneten Verfahren werden geformte Drahtverbindungen 3 zwischen ersten, auf der Chipoberfläche befindlichen Anschlusspunkten 4 und zweiten Anschlusspunkten 5 auf den Kontaktfingern 2b hergestellt. Die Verbindungen 3 werden aus einem feinen Draht gebildet, der von oben durch eine horizontal und vertikal bewegliche Kapillare 12 läuft (Fig. 2). Die Kapillare 12 dient einerseits zum Befestigen (Kontaktieren) des Drahtes an den Punkten 4 und 5 und andererseits zur Führung des Drahtes zwischen diesen Punkten.

Die Kapillare 12 ist Bestandteil einer an sich bekannten, Mikroprozessor-gesteuerten Vorrichtung 10, die die erforderlichen Bewegungszyklen durchführt. Ein Schlitten 14 der Vorrichtung 10 führt Horizontalbewegungen aus (x- und y-Richtungen, Fig.1), angetrieben in bekannter, nicht näher dargestellter Weise z.B. mittels Linearmotor. Der Schlitten 14 trägt beim dargestellten Beispiel eine Wippe 16, die zusammen mit einem auf ihr befestigten Horn 18 um eine horizontale Achse 17 schwenkbar ist (bekannt sind auch vertikal gerichtete Linearführungen für das Horn). Als Schwenkantrieb dient ein auf dem Schlitten 14 befindlicher (Linear-)Motor 15, der die Vertikalbewegungen der Kapillare 12 bewirkt (z-Richtung, Fig. 2). Ueber das Horn 18 wird auch die jeweils für die Kontaktierung in den Punkten 4 und 5 erforderliche Ultraschall-Energie auf die am Ende des Horns eingespannte Kapillare 12 übertragen. Ueber der Kapillare ist normalerweise eine steuerbare Drahtklammer (nicht dargestellt) angeordnet, mit der der Drahtdurchlauf gestoppt oder freigegeben werden kann.

An einem bestimmten Werkstück ist jeweils die Lage aller Kontaktierungspunkte 4 und 5 bekannt, und die generelle Gestalt der zu erzeugenden Drahtbrücken 3 (insbesondere deren maximal zulässige Höhe) wird vorgegeben. Daraus ergeben sich die Richtungen der einzelnen Drahtbrücken (x- und y-Komponenten, Fig. 1) und die benötigten Drahtlängen als Basisdaten für die Programmierung der Bewegungszyklen. Jeweils ausgehend von einem Punkt 4 auf dem Chip 1, an dem der Draht zuerst befestigt wird, folgt die Kapillare 12 einer vorbestimmten Bahn zum zweiten Punkt 5, wobei generell zwei Bewegungsphasen bzw. Bahnabschnitte zu unterscheiden sind (Fig. 2): Die erste Bewegungsphase s1 führt im wesentlichen vom Chip 1 vertikal nach oben, um die erforderliche Drahtlänge durch die Kapillare zu ziehen, und die zweite Phase s2 führt in einem Bogen abwärts auf die Höhe des Kontaktfingers 2b; je nach verlangter Geometrie der Drahtbrücke ist während der ersten Phase s1 eine Vorformung des Drahtes erforderlich, die auch vorübergehende Horizontalbewegungen der Kapillare bedingt. Die in Fig. 3 als Beispiel dargestellte, fertige Drahtbrücke 3 weist z.B. einen Knick 3a auf, der in an sich bekannter Weise durch Vorformung während der ersten Bewegungsphase s1 erzeugt worden ist.

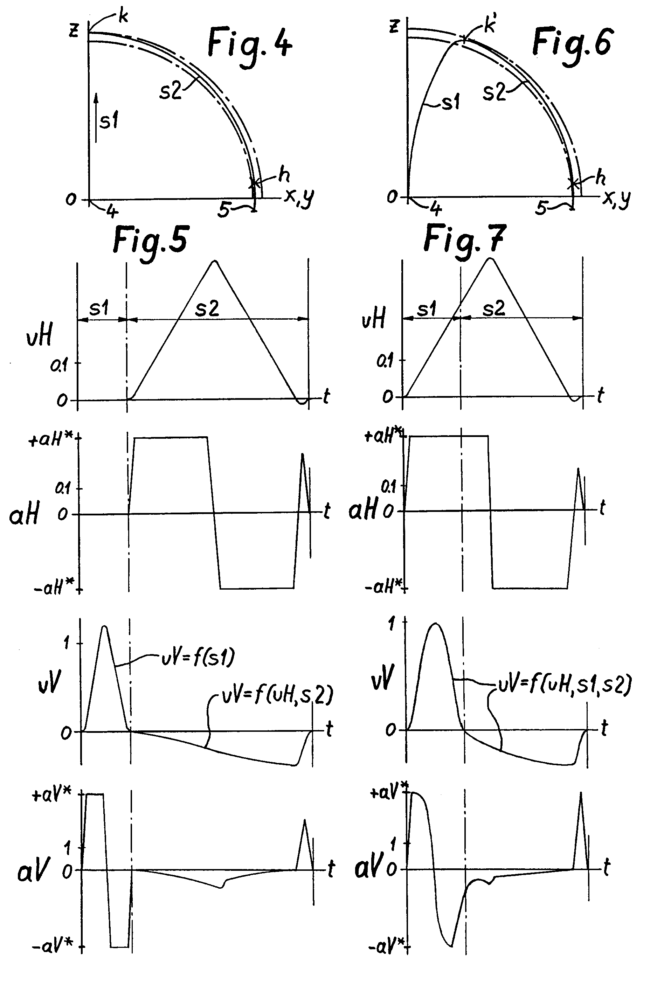

Anhand der Fig. 4 und der zugehörigen Zeitdiagramme in Fig. 5 wird nun ein erstes Ausführungsbeispiel des erfindungsgemässen Verfahrens erläutert: Bei der in Fig. 4 dargestellten Bahn der Kapillare wird vorausgesetzt, dass die erste Bewegungsphase s1 vom ersten Anschlusspunkt 4 direkt vertikal nach oben bis zum höchsten Bahnpunkt k führt (Erzeugung einer relativ einfachen Drahtbrücke ohne Vorformung). Die zweite Phase s2 schliesst im Punkt k mit praktisch horizontaler Tangente an, d.h. die Bahn verläuft diskontinuierlich mit einer Ecke im Punkt k. Im Verlauf der anschliessenden Seitwärts- und Abwärtsbewegung der Kapillare bildet sich im Draht 3 ein Knick, wodurch das weitere Durchziehen durch die Kapillare normalerweise beendet ist (ggf. unterstützt durch Betätigung der Drahtklammer). Beim dargestellten, nach unten zum Anschlusspunkt 5 führenden Bogen der Phase s2 handelt es sich geometrisch z.B. um den Abschnitt einer Spirale, der zwischen zwei konzentrischen, strichpunktiert angedeuteten Kreisbogen verläuft. Gegen das untere Ende des Bogens s2 hin ist zweckmässigerweise ein Punkt h auf bestimmter Höhe definiert, ab welchem eine besondere Stoppsequenz und die Annäherung der Kapillare 12 an den Kontaktfinger 2b eingeleitet wird. Die Bewegungsphase s2 schliesst mit der Kontaktierung des Drahtes auf dem Kontaktfinger ab.

In der Fig. 5 sind untereinander die zugehörigen Zeitfunktionen der horizontalen Geschwindigkeit vH, der horizontalen Beschleunigung aH, der vertikalen Geschwindigkeit vV und der vertikalen Beschleunigung aV dargestellt (überall im gleichen Zeitmassstab). Anzumerken ist, dass die Ordinaten-Massstäbe der horizontalen und der vertikalen Geschwindigkeits- und Beschleunigungs-Diagramme stark verschieden sind, wie aus auf den Ordinatenachsen eingetragenen Vergleichsmarken für Relativwerte hervorgeht (dasselbe gilt für die weiter unten beschriebenen Diagramme der Fig. 7).

In der ersten Bewegungsphase s1 findet keine Horizontalbewegung statt. Für die Vertikalbewegung wird ein Geschwindigkeitsverlauf vV=f(s1) vorgegeben, der entsprechend dem geraden Bahnabschnitt in einen Beschleunigungs- und eine Verzögerungsabschnitt unterteilt ist; dabei wird die Steilheit des Geschwindigkeitsanstiegs und -abfalls so bemessen, dass die maximal zulässigen Beschleunigungs- und Verzögerungswerte +aV* bzw. - aV* erreicht werden.

In der nach einem zwangsläufigen Stopp (vV=0, vH=0) im Punkt k anschliessenden zweiten Phase s2 wird nun die Horizontalgeschwindigkeit vH vorgegeben, im wesentlichen bestehend aus einem Abschnitt mit linearer Geschwindigkeitszunahme und einem folgenden Abschnitt mit linearer Geschwindigkeitsabnahme (gefolgt von der Stoppsequenz bei Erreichen der Höhe h). Die Steilheit dieser Abschnitte wird dabei so bemessen, dass die maximal zulässigen Werte der Horizontalbeschleunigung bzw. -verzögerung +aH* bzw. -aH* über einen wesentlichen Teil der Phase s2 eingehalten werden (kurze Abweichungen am Anfang der Phase und beim Uebergang vom Beschleunigen zum Verzögern sind hauptsächlich durch Spannungsbegrenzung in den Antriebsmotoren bedingt). In Abhängigkeit von dem wie erwähnt vorgegebenen Geschwindigkeitsverlauf vH=f(t) sowie vom vorgegebenen Bahnabschnitt s2 errechnet sich der Verlauf der vertikalen Geschwindigkeit vV sowie der vertikalen Beschleunigung aV (abhängige Variablen). Wie aus Fig. 5 hervorgeht, werden dabei die Grenzwerte +aV* oder -aV* nicht erreicht, d.h. die Begrenzung ist in dieser Phase durch die maximal zulässige Horizontalbeschleunigung gegeben. Es ist aber zu erkennen, dass in beiden Bewegungsphasen s1 und s2 die Bahn von der Kapillare weitgehend mit der maximal zulässigen Geschwindigkeit durchlaufen wird.

Die zum Durchlaufen einer Bahn vom ersten zum zweiten Anschlusspunkt benötigte Zeit lässt sich indessen noch erheblich weiter verkürzen, wie aus dem weiteren Ausführungsbeispiel nach Fig. 6 und 7 hervorgeht (die Diagramme der Fig. 7 sind im gleichen Zeitmassstab dargestellt wie diejenigen von Fig. 5, und es ist die gleiche Distanz zwischen den Anschlusspunkten 4 und 5 vorausgesetzt). Die Bahn nach Fig. 6 zeichnet sich dadurch aus, dass eine "Ecke" im Punkt k nach Fig. 4 vermieden wird und die Bahnabschnitte s1 und s2 in einem höchsten Punkt k' kontinuierlich ineinander übergehen; dies kann auch so aufgefasst werden, dass der Abschnitt s1 sich einer nach rückwärts gedachten Verlängerung des Abschnittes s2 (oder dem Abschnitt s2 nach Fig.4) asymptotisch nähert. Ein solcher stetiger Uebergang wird gemäss Fig. 7 dadurch erreicht, dass man die (vorgegebene) Horizontalbewegung bereits während der ersten Bewegungsphase s1 beginnen lässt. Im Gegensatz zum Beispiel nach Fig. 4 und 5 erfolgen also die Vertikal- und Horizontalbewegungen bereits in der Phase s1 simultan. Wiederum errechnen sich die Vertikalgeschwindigkeit vV und die entsprechende Vertikalbeschleunigung aV als abhängige Variablen aufgrund der vorbestimmten Horizontalgeschwindigkeit vH und der Bahn, hier jedoch bereits in der ersten Phase s1. Die Bemessung der Geschwindigkeitszunahme und -abnahme von vH richtet sich nach den maximal zulässigen horizontalen wie auch vertikalen Beschleunigungen.

Ein kontinuierlicher Bahnübergang in einem Punkt k' zwischen den Phasen s1 und s2 lässt sich analog auch dann verwirklichen, wenn - in Abweichung vom Beispiel nach Fig. 6 und 7 - während der ersten Phase eine Vorformung des Drahtes stattfindet. Der zum Uebergangspunkt k' führende, ansteigende Bahnabschnitt geht dann nicht direkt vom Anschlusspunkt 4 aus, sondern schliesst an die betreffenden, auch Seitwärtsbewegungen umfassenden Vorformbewegungen der Kapillare an. Die Bahnberechnung und die Bewegungsabläufe des anschliessenden Abschnittes s1 erfolgen analog, jedoch mit entsprechend geändertem Ausgangspunkt. - Entsprechendes gilt auch, wenn, als Variante zum Ausführungsbeispiel nach Fig. 4 und 5, eine an den Anschlusspunkt 4 anschliessende Vorformung erforderlich ist: Der Abschnitt s1 führt dann nicht direkt vom Punkt 4 vertikal, sondern vom Endpunkt der Vorformbewegungen schräg nach oben zum Eckpunkt k.

Es ist noch zu erwähnen, dass in gewissen Fällen - vor allem bei besonders hohen Anforderungen an die Genauigkeit und Gleichmässigkeit der Drahtbrücken - die durch die Antriebsvorrichtung in x-, y- und z-Richtung gegebenen mechanischen Grenzwerte eventuell nicht voll ausgenützt werden können. Zudem geht der an sich vorteilhafte stetige Bahnverlauf im Punkt k' nach Fig. 6 möglicherweise mit einer grösseren Streuung beim Abmessen der Drahtlänge einher, was wiederum zu entsprechenden Abweichungen in der Geometrie der Drahtbrücken führen kann. Diesem Umstand kann aber durch geeignete Steuerung der über der Kapillare angeordneten (weiter oben erwähnten) Drahtklammer mindestens teilweise begegnet werden.

## Patentansprüche

1. Verfahren zur Herstellung einer geformten Drahtverbindung zwischen einem ersten, auf einem Halbleiterchip (1) befindlichen Anschlusspunkt (4) und einem zweiten Anschlusspunkt (5),
wobei ein Draht (3) durch eine mittels programmierbarer Antriebsvorrichtung (10) horizontal und vertikal beweglich geführte Kapillare (12) hindurchläuft, die sowohl zum Befestigen des Drahtes an beiden Anschlusspunkten als auch zur Drahtführung zwischen den beiden Anschlusspunkten dient,
und wobei, nach Befestigung des Drahtes (3) am ersten Anschlusspunkt (4), die Kapillare (12) von der Antriebsvorrichtung entlang einer vorbestimmten Bahn zum zweiten Anschlusspunkt (5) geführt wird, und zwar in einer ersten Bewegungsphase (s1) im wesentlichen vertikal nach oben, um die benötigte Drahtlänge durchzuziehen, und in einer zweiten Bewegungsphase (s2) entlang einem Bogen nach unten zum zweiten Anschlusspunkt,
dadurch **gekennzeichnet,**
dass man mindestens in der zweiten Bewegungsphase (s2) die Geschwindigkeit (vH) der horizontalen Bewegungskomponente vorgibt und danach die Geschwindigkeit (vV) der vertikalen Bewegungskomponente aufgrund der vorgegebenen Bahn berechnet,
und dass man dabei die Vorgabe der Geschwindigkeitswerte (vH) der horizontalen Bewegungskomponente nach den maximal zulässigen Horizontal- und/oder Vertikal-Beschleunigungen (aH*, aV*) ausrichtet.

2. Verfahren nach Anspruch 1, dadurch gekennzeichnet, dass man die Horizontalbewegung bereits während der ersten Bewegungsphase (s1) beginnen lässt und durch simultane Vertikal- und Horizontalbewegungen einen stetigen Uebergang der Bahn von der ersten (s1) in die zweite Bewegungsphase (s2) erzeugt.

3. Verfahren nach Anspruch 1 oder 2, dadurch gekennzeichnet, dass im Falle von an den ersten Anschlusspunkt (4) anschliessenden Vorformbewegungen die erste Bewegungsphase (s1) von deren Endpunkt ausgeht.

## Claims

1. A method for making a wire connection of predetermined shape between a first connection point (4) located on a semiconductor chip (1) and a second connection point (5), wherein a wire (3) passes through a capillary (12) movable horizontally and vertically by means of a programmable drive mechanism (10) that is used both to bond the wire to the two connection points and to guide the wire between the two connection points and in which, after attachment of the wire (3) to the first connection point (4), the drive mechanism guides the capillary (12) along a specified trajectory to the second connection point (5), that is to say in a first travel stage (s1) more or less vertically upward, in order to pull through the required length of wire, and in a second travel stage (s2) in a downward arc to the second connection point, **characterized in that** at least in the second travel stage (s2) the speed (vH) of the horizontal component of the movement is preset and after that the speed of the vertical component (vV) of the movement is calculated on the basis of the specified trajectory, and in that the presetting of the speed of the horizontal component of movement (vH) is based upon the maximum permissible horizontal and/or vertical accelerations (aH*, aV*).

2. A method according to claim 1, **characterized in that** the horizontal movement is programmed to start during the first travel stage (s1) and in that a steady transition of the trajectory from the first (s1) to the second travel stage (s2) is produced by simultaneous vertical and horizontal movements.

3. A method according to claim 1 or 2, **characterized in that** in the case of preforming movements starting at the first connection point the first travel stage (s1) originates at the end point of said preforming movements.

## Revendications

1. Procédé de fabrication d'une connexion filaire configurée entre un premier point de raccordement (4) qui se trouve sur une microplaquette semi-conductrice (1) et un deuxième point de raccordement (5),
◆ dans lequel un fil (5) se propage à travers un capillaire (12) guidé, qui est mobile horizontalement et verticalement sous l'effet d'un dispositif d'entraînement programmable et qui sert tant à fixer le fil aux deux points de raccordement qu'à guider le fil entre les deux points de raccordement, et
◆ dans lequel le capillaire guidé est guidé, après la fixation du fil (3) au premier point de raccordement (4), par le dispositif d'entraînement le long d'un trajet prédéfini vers le deuxième point de raccordement (5) et ceci dans une première phase de déplacement (s1) ascendant sensiblement vertical afin de tirer à travers le capillaire la longueur de fil nécessaire et dans une deuxième phase de déplacement (s2), le long d'un arc descendant, vers le deuxième point de raccordement,
caractérisé en ce que
◆ la vitesse (vH) selon la composante horizontale de déplacement est prédéfinie au moins dans la deuxième phase de déplacement (s2) et la vitesse de déplacement (vV) selon la composante verticale de déplacement est ensuite calculée sur la base du trajet prédéfini, et en ce que
◆ la définition préalable des valeurs de vitesse (vH) selon la composante horizontale de déplacement est ajustée en fonction des accélérations horizontale et"ou verticale maximales admissibles (aH*, aV*).

2. Procédé selon la revendication 1, caractérisé en ce que
◆ on fait déjà débuter le déplacement horizontal pendant la première phase de déplacement (s1) et qu'une transition stable du trajet, entre la première phase (s1) et la deuxième phase (s2) de déplacement, est engendrée au moyen de déplacements simultanés vertical et horizontal.

3. Procédé selon la revendication 1 ou 2, caractérisé en ce que, dans le cas où des déplacements de préformage suivraient immédiatement la fixation au premier point de raccordement (4), la première phase de déplacement (s1) commence à leur point final.
